# EUROPÄISCHE PATENTSCHRIFT

(11) **EP 1 114 457 B1**
(45) Veröffentlichungstag und Bekanntmachung des Hinweises auf die Patenterteilung: **12.05.2010**
(21) Anmeldenummer: 99952270.9
(22) Anmeldetag: 02.08.1999
(51) Int. Cl.: H01L 23/31, H01L 23/498

(54) **VERFAHREN ZUR HERSTELLUNG VON INTEGRIERTEN SCHALTKREISEN**
METHOD FOR PRODUCING INTEGRATED CIRCUITS
PROCÉDÉ DE PRODUCTION DE CIRCUITS INTÉGRÉS

(30) Priorität: 21.08.1998 DE 19838153
(43) Veröffentlichungstag der Anmeldung: 11.07.2001
(73) Patentinhaber: Infineon Technologies AG, 85579 Neubiberg (DE)
(72) Erfinder: HACKE, Hans-Jürgen, D-81475 München (DE)
(74) Vertreter: Viering, Jentschura & Partner
(86) Internationale Anmeldenummer: PCT/DE1999/002412
(87) Internationale Veröffentlichungsnummer: WO 2000/011715

(56) Entgegenhaltungen:
- EP-A- 0 704 895
- EP-A- 0 734 059
- EP-A- 0 786 808

## Beschreibung

Die Erfindung betrifft ein Verfahren zur Herstellung von integrierten Schaltkreisen.

Im Stand der Technik sind Fertigungsverfahren zur Herstellung von integrierten Schaltkreisen insbesondere Chip-Size-Packages aus Halbleiterwafern bekannt, bei denen in einem ersten Schritt auf einer aktiven Seite eines Halbleiterwafers Schaltungsstrukturen für mehrere integrierte Schaltkreise hergestellt werden. Danach werden die integrierten Schaltkreise in sogenannte Chips vereinzelt, indem der Halbleiterwafer an den Randbereichen der integrierten Schaltkreise in Einzelstücke zersägt wird. Die Chips werden jeweils auf sogenannte Interposer kontaktiert, die starr oder flexibel ausgebildet sein können. Es ist auch denkbar, einen Chip auf ein sogenanntes Leadframe zu kontaktieren. Die Kontaktierung kann mit unterschiedlichen Kontaktierverfahren vorgenommen werden, zum Beispiel mit einem Draht-Kontaktierverfahren, mit einem Flip-Chip-Kontaktierverfahren oder mit einem TAB-Kontaktierverfahren.

In EP 0 734 059 A2, EP 0 786 808 A1 und EP 0 704 895 A2 sind Herstellungsverfahren für Anschlusskontakte auf Halbleiterschaltungen beschrieben, bei denen die Oberseite eines Wafers mit einer Passivierung versehen wird und eine darüber angeordnete leitfähige Schicht strukturiert und mit Durchkontaktierungen zu Anschlusspads einer Schaltung versehen wird.

Es ist Aufgabe der Erfindung, ein vereinfachtes Verfahren zur Herstellung von integrierten Schaltkreisen anzugeben.

Die Merkmale des Oberbegriffes des Hauptanspruchs sind aus der EP 0 734 059 A2 bekannt.

Die gestellte Aufgabe wird durch das Verfahren mit den Merkmalen des Anspruches 1 gelöst. Vorteilhafte Weiterbildungen ergeben sich aus den abhängigen Ansprüchen.

Das erfindungsgemäße Verfahren zur Herstellung von integrierten Schaltkreisen weist die folgenden Schritte auf:
- Vorsehen eines Halbleiterwafers, der eine aktive Seite mit Schaltungsstrukturen für wenigstens zwei integrierte Schaltkreise aufweist und dessen Anschlüsse durch Kleben, Löten oder Schweißen kontaktierbar sind,
- Aufbringen wenigstens einer elektrisch isolierenden Zwischenschicht auf die aktive Seite des Halbleiterwafers,
- Aufbringen wenigstens einer elektrisch leitenden Leitungsfolie auf die Zwischenschicht,
- Herstellen von leitenden Verbindungen zwischen den Anschlüssen und der Leitungsfolie,
- Ausbilden von Leitungsbahnen in der Leitungsfolie,
- Erzeugung von Kontakthöckern oder Balls gegebenenfalls nach Erzeugung einer Maskierungsschicht,
- Zerteilen des Halbleiterwafers in integrierte Schaltkreise.

Das erfindungsgemäße Verfahren gewährleistet eine einfache Herstellung von integrierten Schaltkreisen. Zunächst wird eine relativ dicke organische Dielektrikumsschicht zum Dehnungsausgleich vorgesehen. Die endgültige Leiterstruktur mit kräftigen Leiterquerschnitten wird erst auf der Scheibenebene des Halbleiterwafers erzeugt. Das Grundprinzip beruht darauf, eine Kupferfolie auf den Halbleiterwafer zu laminieren, die Kupferfolie mit den Chipanschlüssen bzw. den Anschlußkontakten der integrierten Schaltkreise zu kontaktieren und erst dann in Photo- und Ätztechnik die Umverdrahtung zu realisieren.

Darauf kann eine Harzabdeckung zur Löt-Stop-Maskierung der Anschlüsse folgen. Schließlich kann die Applikation von Lotbällen und das Trennen des Halbleiterwafers in Einzelpackages erfolgen, beispielsweise durch Sägen. Generell kann zur Erzielung einer besonders ebenen Fläche eines Halbleiterchips zusammen mit dem Auflaminieren der Kupferfolie eine geeignete Gegenkaschierung auf der passiven Chiprückseite erfolgen.

In Weiterbildung der Erfindung wird der Schritt des Aufbringens der Zwischenschicht auf wenigstens eine elektrisch leitende Leitungsfolie vor dem Schritt des Aufbringens der Zwischenschicht auf die aktive Seite des Halbleiterwafers durchgeführt. Von dieser Ausgestaltung des erfindungsgemäßen Verfahrens gehen die Varianten aus, bei denen die Zwischenschicht zusammen mit der Leitungsfolie vor dem Aufbringen auf den Halbleiterwafer fertig hergestellt wird. Bei diesen Ausgestaltungen des erfindungsgemäßen Verfahrens ist besonders von Vorteil, daß Herstellungsschritte, die an der Zwischenschicht und an der Leitungsfolie durchgeführt werden, die integrierten Schaltkreise auf dem Halbleiterwafer nicht beeinflussen.

Dabei kann vor dem Schritt des Aufbringens der Zwischenschicht auf die aktive Seite des Halbleiterwafers der Schritt des Einbringens wenigstens einer Durchgangsöffnung in die Zwischenschicht vorgesehen sein, wobei die Durchgangsöffnung so ausgebildet ist, daß sie sich ausgehend von einer Unterseite der Leitungsfolie auf die Unterseite der Zwischenschicht erstreckt. Dann kann die Leitungsfolie durch die Durchgangsöffnung hindurch kontaktiert werden. Das Einbringen der Durchgangsöffnung wird vorzugsweise mit einem Laserverfahren durchgeführt, wodurch sich genaue Durchgangsöffnungen erzielen lassen.

Zum Kontaktieren der Leitungsfolie durch die Zwischenschicht hindurch kann leitendes Füll- und Verbindungsmaterial in die Durchgangsöffnung eingebracht werden, und zwar insbesondere durch ein galvanisches Abscheidungsverfahren. Dadurch wird erfindungsgemäß eine besonders kostengünstige und zuverlässige Herstellung eines Halbleiterwafers erreicht.

Zur Kontaktierung der Leitungsfolie mit Kontaktpunkten von integrierten Schaltkreisen auf dem Halbleiterwafer kann der Schritt des Erwärmens des Lotmaterials in der Durchgangsöffnung vorgesehen sein, und zwar nach dem Aufbringen der Zwischenschicht auf die aktive Seite des Halbleiterwafers. Bei dem Erwärmen des Lotmaterials in der Durchgangsöffnung wird das Lotmaterial aufgeschmolzen und geht mit den auf dem Halbleiterwafer vorgesehenen Kontaktpunkten eine leitende Verbindung ein. Eine solche Erwärmung wird vorzugsweise punktuell auf der Leitungsfolie im Bereich der Durchgangsöffnung durchgeführt, so daß die Wärmeeinwirkung auf den Halbleiterwafer besonders gering ist.

Abweichend von den vorstehend aufgeführten Ausgestaltungen des erfindungsgemäßen Verfahrens kann auch Leitkleber als leitendes Füll- und Verbindungsmaterial in die Durchgangsöffnung eingebracht werden und zwar insbesondere durch ein Rakelverfahren. Das Vorsehen von Leitkleber in den Durchgangsöffnungen begünstigt eine Großserienfertigung des Halbleiterwafers. Dabei kann nach dem Schritt des Aufbringens der Zwischenschicht auf die aktive Seite des Halbleiterwafers der Schritt des Aushärtens des Leitklebers in den Durchgangsöffnungen vorgesehen sein, und zwar derart, daß der Leitkleber sowohl mit der Leitungsfolie als auch mit auf dem Halbleiterwafer vorgesehenen Kontaktpunkten eine leitende Verbindung eingeht. Eine besonders günstige Verbindung zwischen dem Halbleiterwafer, der Zwischenschicht und der Leitungsfolie ergibt sich dann, wenn der Schritt des Aufbringens der Zwischenschicht auf die aktive Seite des Halbleiterwafers mit einem Laminierverfahren insbesondere unter Anwendung von Druck und Hitze durchgeführt wird.

Die vorstehend erläuterten Verfahren führen zu einem Halbleiterwafer, auf dem eine isolierende Zwischenschicht und darauf eine leitende Leitungsfolie ausgebildet ist. Anschließend werden Leitungsbahnen in der Leitungsfolie ausgebildet, und zwar insbesondere mit einem ätztechnischen Verfahren durch Wegätzen von Bereichen der Leitungsfolie. Hierzu können herkömmliche Techniken verwendet werden, wobei insbesondere der Schritt des Beschichtens der Leitungsfolie mit Ätzstopplack sowie das Ausbilden von Leiterbahnen mit Hilfe von photolithographischen Schritten vorgesehen sein kann.

Schließlich wird der Schritt des Lötstoppmaskierens von Ball-Landeflächen sowie der Schritt einer Lötballerzeugung auf vorbestimmten Stellen der Leitungsfolie durchgeführt, was eine spätere Kontaktierung der auf dem Halbleiterwafer vorgesehenen integrierten Schaltkreise vereinfacht.

Ein erfindungsgemäß hergestellter Halbleiterwafer zeichnet sich durch eine aktive Seite mit Schaltungsstrukturen aus, wobei auf der aktiven Seite wenigstens eine elektrisch isolierende Zwischenschicht sowie wenigstens eine elektrisch leitende Leitungsfolie mit Leitungsbahnen vorgesehen sind. Dabei ist zwischen Kontaktpunkten auf dem Halbleiterwafer und Bereichen der Leitungsfolie leitendes Füll- und Verbindungsmaterial vorgesehen.

Der fertiggestellte Halbleiterwafer wird in einzelne integrierte Schaltkreise zersägt. Dies geschieht mit sehr schnell laufenden Trennscheiben, die mit Diamantpartikeln bestückt sind. Die Diamantpartikel sind sehr dünn und so in einen Dorn eingespannt, daß sie wenig Überstand haben. Dazu wird ein Blatt numerisch gesteuert und genau getaktet in dem Rasterabstand der integrierten Schaltkreise über den Halbleiterwafer gefahren, so daß die integrierten Schaltkreise abgetrennt werden. Vorher wird der Halbleiterwafer auf eine Folie aufgeklebt, so daß die integrierten Schaltkreise während des Sägevorgangs in ihrer Ordnung verbleiben. Diese Folie wird beim Zersägen des Halbleiterwafers mitangesägt.

Die Erfindung ist in der Beschreibung anhand von Ausführungsbeispielen näher veranschlaulicht.

Die Figuren 1 - 7 veranschaulichen die Herstellung eines Halbleiterwafers anhand eines Querschitts durch dessen Schichten für ein erstes Ausführungsbeispiel.

Die Figuren 8 - 13 veranschaulichen die Herstellung eines Halbleiterwafers anhand eines Querschnitts durch dessen Schichten für ein zweites Ausführungsbeispiel.

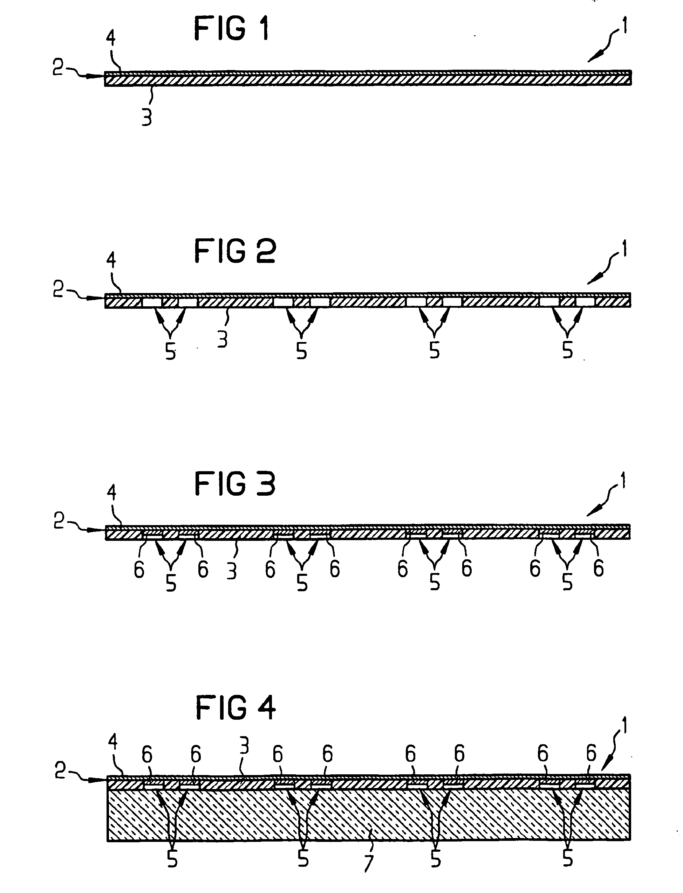

Figur 1 zeigt einen Querschnitt durch eine Leiterplatte 2, die sich in eine elektrisch isolierende Zwischenschicht 3 sowie in eine auf der elektrischen Zwischenschicht 3 flächig aufgebrachte und elektrisch leitende Kupferkaschierung 4 gliedert.

In Figur 1 liegt die Leiterplatte 2 im Grundzustand vor, das heißt als mit Kupfer kaschiertes B-Stage-Material oder als kleberbeschichtetes Trägermaterial.

Figur 2 veranschaulicht den ersten Herstellungsschritt für den Halbleiterwafer 1. In diesem Schritt werden in die Zwischenschicht 3 der Leiterplatte 2 Durchgangsöffnungen 5 eingebracht, die sich ausgehend von der Kupferkaschierung 4 bis zur Unterseite der Zwischenschicht 3 erstrecken. Hierfür wird vorzugsweise ein Laserverfahren verwendet.

Figur 3 veranschaulicht einen weiteren Herstellungsschritt zur Herstellung des Halbleiterwafers 1. In diesem Schritt wird Lotmaterial 6 in Form von Zinn galvanisch in den Durchgangsöffnungen 5 abgelagert, wobei das Lotmaterial 6 an der Unterseite der Kupferkaschierung 4 anliegt.

Figur 4 veranschaulicht einen weiteren Herstellungsschritt zur Herstellung des Halbleiterwafers 1. Dabei wird die Leiterplatte 2 aus Figur 3 auf eine Halbleiterscheibe 7 aufgebracht, die auf ihrer Oberseite integrierte Schaltkreise aufweist. Die Verbindung der Leiterplatte 2 mit der Halbleiterscheibe 7 wird durch Auflaminieren hergestellt. Die Leiterplatte 2 wird dabei so auf die Halbleiterscheibe 7 auflaminiert, daß die Durchgangsöffnungen 5 genau über in dieser Ansicht nicht gezeigten Ni/Au-Höckern von integrierten Schaltkreisen auf der Halbleiterscheibe 7 zu liegen kommt.

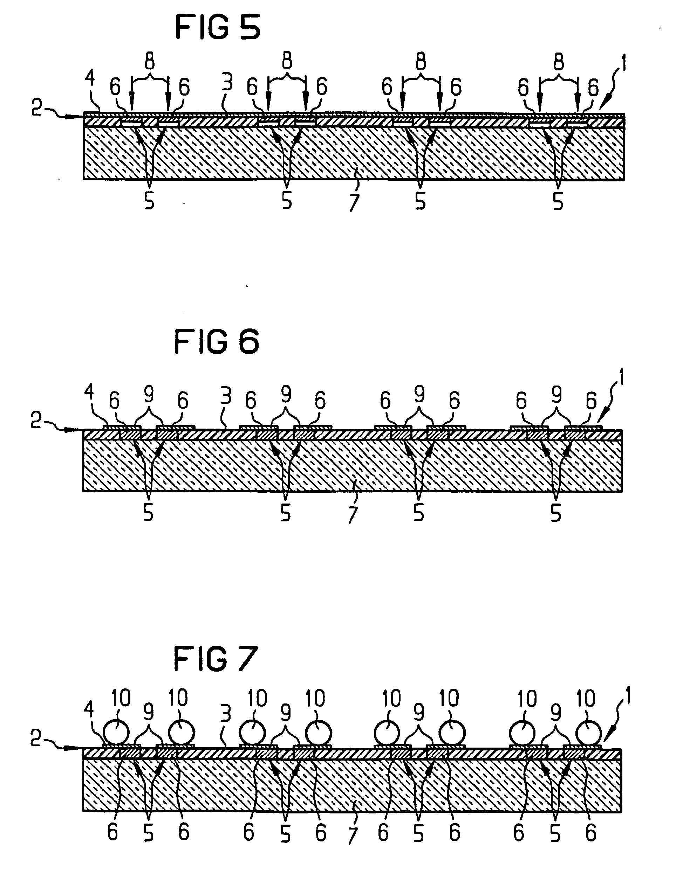

Figur 5 veranschaulicht einen weiteren Herstellungsschritt bei der Herstellung des Halbleiterwafers 1.
Durch punktförmige Erwärmung der Oberseite der Leiterplatte 2 in Bereichen um Durchgangsöffnungen 5 herum wird mit Hilfe von Laserstrahlen 8 das Lotmaterial 6 aufgeschmolzen, so daß es eine innige Verbindung mit den in dieser Ansicht nicht dargestellten benetzbaren Anschlüssen, z.B. Ni/Au-Höckern und mit entsprechenden Bereichen der Kupferkaschierung eingeht und eine elektrisch leitende Verbindung zwischen der Kupferkaschierung 4 und Kontaktbereichen der integrierten Schaltkreise auf der Halbleiterscheibe 7 herstellt.

Figur 6 zeigt einen weiteren Schritt bei der Herstellung des Halbleiterwafers 1. In diesem Schritt werden in der Kupferkaschierung 4 mit Hilfe einer photolithographischen Technik und mit Hilfe einer Ätztechnik Leiterbahnen 9 ausgebildet, die eine wahlweise Kontaktierung der Durchgangsöffnungen 5 erlauben.

Figur 7 veranschaulicht einen weiteren Herstellungsschritt des Halbleiterwafers 1. In diesem Schritt werden die Leiterbahnen 9 mit einer in dieser Ansicht nicht gezeigten Lötstoppmaskierung versehen, worauf sogenannte Balls 10 auf den Leiterbahnen 9 erzeugt werden. In einem hier nicht näher veranschaulichten Herstellungsschritt wird anschließend der Halbleiterwafer 1 in sogenannte Einzelchips zersägt.

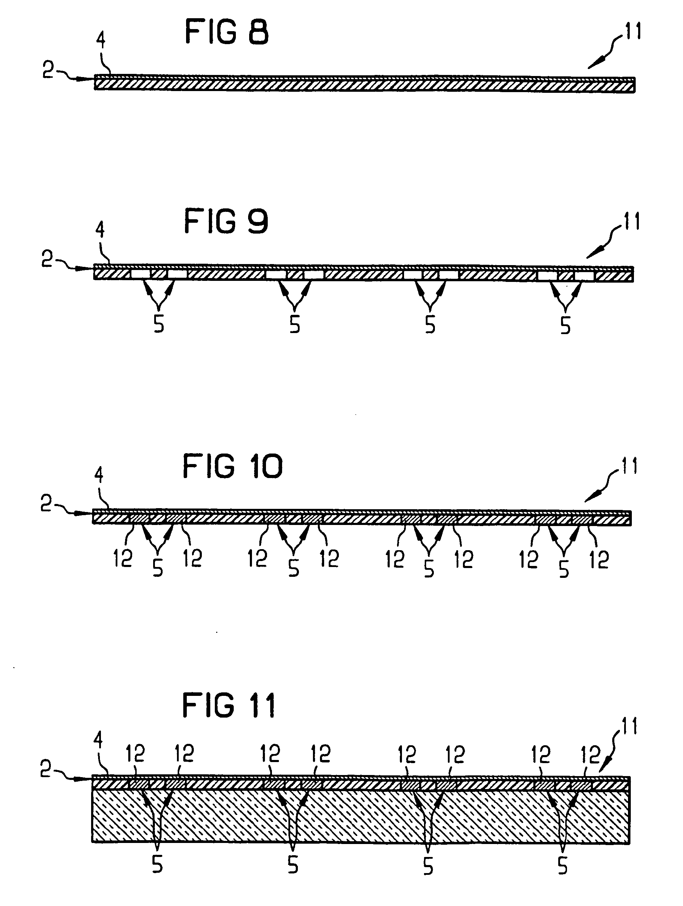

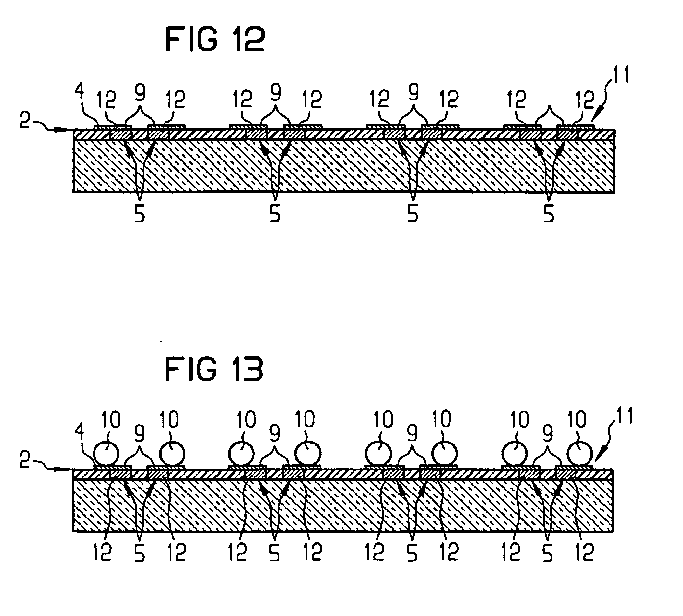

Die Figuren 8-13 veranschaulichen die Herstellung eines weiteren Halbleiterwafers 11 anhand mehrerer Querschnitte. Die Herstellung des Halbleiterwafers 11 entspricht im wesentlichen der Herstellung des Halbleiterwafers 1. Gleichen Teilen sind deshalb dieselben Bezugsziffern gegeben.

Im Unterschied zum Halbleiterwafer 1 aus den Figuren 1 - 7 wird beim Halbleiterwafer 11 im Herstellungsschritt gemäß Figur 10 Leitkleber 12 in die Durchgangsöffnungen 5 eingerakelt. Bei dem Auflaminieren der Leiterplatte 2 auf die Halbleiterscheibe 7 wird der in den Durchgangsöffnungen 5 eingebrachte Leitkleber 12 gleichzeitig ausgehärtet.

Alle anderen Herstellungsschritte zur Herstellung des Halbleiterwafers 11 stimmen im wesentlichen mit den Herstellungsschritten für den Halbleiterwafer überein.

## Patentansprüche

1. Verfahren zur Herstellung von integrierten Schaltkreisen, das die folgenden Schritte aufweist:
- Vorsehen eines Halbleiterwafers (7;21), der eine aktive Seite mit Schaltungsstrukturen für wenigstens zwei integrierte Schaltkreise aufweist,
- Aufbringen wenigstens einer elektrisch isolierenden Zwischenschicht (2; 22) auf eine aktive Seite des Halbleiterwafers (7, 21),
- Aufbringen wenigstens einer elektrisch leitenden Leitungsfolie (4, 25) auf die Zwischenschicht (2; 22), wobei das Aufbringen der Leitungsfolie (4) auf die Zwischenschicht vor dem Aufbringen der Zwischenschicht (2) auf die aktive Seite des Halbleiterwafers (7) vorgesehen ist,
- Ausbilden von Leitungsbahnen (9) in der Leitungsfolie (4, 25),
- Zerteilen des Halbleiterwafers (7, 21) in integrierte Schaltkreise,
**dadurch gekennzeichnet ,**
**daß** vor dem Schritt des Aufbringens der Zwischenschicht (2) auf die aktive Seite des Halbleiterwafers (7) der Schritt des Einbringens wenigstens einer Durchgangsöffnung (5) in die Zwischenschicht (2) vorgesehen ist,
wobei die Durchgangsöffnung bzw. die Durchgangsöffnungen (5) so ausgebildet ist bzw. sind, daß sie sich ausgehend von einer Unterseite der Leitungsfolie(4) auf die Unterseite der Zwischenschicht (2) erstreckt bzw. erstrecken, wobei das Einbringen der Durchgangsöffnung bzw. der Durchgangsöffnungen (5) insbesondere mit einem Laserverfahren durchgeführt wird, und
**daß** leitende Verbindungen zwischen auf dem Halbleiterwafer (7) vorgesehenen Kontaktpunkten und den Leitungsbahnen (9) über die Durchgangsöffnung bzw. die Durchgangsöffnungen (5) hergestellt werden.

2. Verfahren nach Anspruch 1,
**dadurch gekennzeichnet ,**
**daß** der Schritt des Einbringens von leitendem Füll- und Verbindungsmaterial in die Durchgangsöffnung bzw. Durchgangsöffnungen (5) vorgesehen ist.

3. Verfahren nach Anspruch 2,
**dadurch gekennzeichnet ,**
**daß** Lotmaterial als leitendes Füll- und Verbindungsmaterial in die Durchgangsöffnung bzw. die Durchgangsöffnungen (5) eingebracht wird, und zwar insbesondere durch ein galvanisches Abscheidungsverfahren.

4. Verfahren nach Anspruch 3,
**dadurch gekennzeichnet ,**
**daß** nach dem Schritt des
- Aufbringens der Zwischenschicht (2) auf die aktive Seite des Halbleiterwafers (7)
der Schritt des
- Erwärmens des Lotmaterial in der Durchgangsöffnung bzw. den Durchgangsöffnungen (5)
vorgesehen ist, und zwar derart, daß das Lotmaterial durch das Erwärmen aufgeschmolzen wird und mit auf dem Halbleiterwafer vorgesehenen Kontaktpunkten eine leitende Verbindung eingeht.

5. Verfahren nach Anspruch 2,
**dadurch gekennzeichnet ,**
**daß** Leitkleber als leitendes Füll- und Verbindungsmaterial in die Durchgangsöffnung bzw. die Durchgangsöffnungen eingebracht wird, und zwar insbesondere durch ein Rakelverfahren .

6. Verfahren nach Anspruch 3,
**dadurch gekennzeichnet ,**
**daß** daß nach dem Schritt des
- Aufbringens der Zwischenschicht auf die aktive Seite des Halbleiterwafers
der Schritt des
- Aushärtens des Leitklebers in der Durchgangsöffnung bzw. den Durchgangsöffnungen
vorgesehen ist, und zwar derart, daß der Leitkleber mit auf dem Halbleiterwafer vorgesehenen Kontaktpunkten eine leitende Verbindung eingeht.

7. Verfahren nach einem der vorhergehenden Ansprüche, **dadurch gekennzeichnet ,**
**daß** der Schritt des
- Aufbringens der Zwischenschicht auf die aktive Seite des Halbleiterwafers
mit einem Laminierverfahren insbesondere unter Anwendung von Druck und Hitze durchgeführt wird.

8. Verfahren nach einem der vorhergehenden Ansprüche, **dadurch gekennzeichnet ,**
**daß** der Schritt des
- Ausbildens von Leitungsbahnen (9) in der Leitungsfolie (25) mit einem ätztechnischen Verfahren durch Wegätzen von Bereichen der Leitungsfolie (25) vorgenommen wird.

9. Verfahren nach Anspruch 8,
**dadurch gekennzeichnet**,
vor dem Schritt des Wegätzens von Bereichen der Leitungsfolie der Schritt des Bedruckens der Leitungsfolie mit Ätzstopplack vorgesehen ist.

## Claims

1. A method to manufacture integrated circuits that comprises the following steps:
- providing a semiconductor wafer (7; 21) having an active side with circuit structures for at least two integrated circuits,
- applying at least one electrically isolating intermediate layer (2; 22) to an active side of the semiconductor wafer (7; 21),
- applying at least one electrically conductive conductor foil (4, 25) to the intermediate layer (2; 22), wherein the applying of the conductor foil (4) to the intermediate layer (2) is provided before the applying of the intermediate layer (2) to the active side of the semiconductor wafer (7),
- forming conductor tracks (9) in the conductor foil (4, 25),
- dividing the semiconductor wafer (7, 21) into integrated circuits,
**characterized in:**
**that** before applying the intermediate layer (2) to the active side of the semiconductor wafer (7) the step of forming at least one through-opening (5) in the intermediate layer is provided, wherein the at least one through-opening (5) is formed such that it extends from an underside of the conductor foil (4) to the underside of the intermediate layer (2), wherein the forming of the at least one through-opening (5) is done with a laser method,
and
**that** conductive connections are formed between contact points provided on the semiconductor wafer (7) and the conductor tracks (9) via the at least one through-opening (5).

2. The method according to claim 1, **characterized in**
**that** the step of introducing a conductive filling and connecting material into the at least one through-opening (5) is provided.

3. The method according to claim 2, **characterized in**
**that** a solder material is introduced as conductive filling and connecting material into the at least one through-opening (5), and that in particular, an electrodeposition process is used.

4. The method according to claim 3, **characterized in**
**that** after the step of
depositing the intermediate layer (2) to the active side of the semiconductor wafer (7) the step is provided of
heating the solder material in the at least one through-opening (5)
such that the solder material is melted by the heating and forms a conductive connection with contact points provided on the semiconductor wafer.

5. The method according to claim 2, **characterized in**
**that** conductive adhesive is introduced as conductive filling and connecting material into the at least one through-opening, and in particular by using a doctor blade method.

6. The method according to claim 3, **characterized in**
**that that** after the step of applying of the intermediate layer on the active side of the semiconductor wafer
the step of curing the conductive adhesive in the at least one through-opening is provided such that the conductive adhesive forms a conductive connection with contact points provided on the semiconductor wafer.

7. The method according to one of the preceding claims, **characterized in**
**that** the step of applying the intermediate layer to the active side of the semiconductor wafer is performed by a lamination method, in particular by application of pressure and heat.

8. The method according to one of the preceding claims, **characterized in**
**that** the step of forming of the conductor tracks (9) in the electrically conductive conductor foil (25) is performed by an etching method which etches away areas of the electrically conductive conductor foil (25).

9. The method according to claim 8, **characterized in**
**that** before the step of etching away the areas of the electrically conductive conductor foil, the step of coating the electrically conductive conductor foil with an etching resist coating is provided.

## Revendications

1. Procédé de production de circuits intégrés, qui a les stades suivants :
- on prévoit une tranche (7 ; 21) semi-conductrice qui a une face active ayant des structures de circuit pour au moins deux circuits intégrés,
- on dépose au moins une couche (2 ; 22) intermédiaire isolante du point de vue électrique sur une face active de la tranche (7 ; 21) semi-conductrice,
- on dépose au moins une feuille (4 ; 25) de conduction conductrice de l'électricité sur la couche (2 ; 22) intermédiaire, le dépôt de la feuille (4) de conduction sur la couche intermédiaire étant effectué avant le dépôt de la couche (2) intermédiaire sur la face active de la tranche (7) semi-conductrice,
- on forme des pistes (9) de conduction dans la feuille (4, 25),
- on subdivise la tranche (7, 21) semi-conductrice en des circuits intégrés,
**caractérisé**
**en ce qu'**avant le stade de dépôt de la couche (2) intermédiaire sur la face active de la tranche (7) semi-conductrice, on prévoit le stade dans lequel on ménage au moins une ouverture (5) de traversée dans la couche (2) intermédiaire,
l'ouverture de traversée ou les ouvertures (5) de traversée étant telles qu'elles s'étendent en partant d'une face inférieure de la feuille (4) de conduction jusqu'à la face inférieure de la couche (2) intermédiaire, en ménageant l'ouverture de traversée ou les ouvertures (5) de traversée notamment par un procédé laser, et
**en ce que** l'on produit des liaisons conductrices entre des points de contact sur la tranche (7) semi-conductrice et les pistes (9) de conduction par l'ouverture de traversée ou par les ouvertures (5) de traversée.

2. Procédé suivant la revendication 1,
**caractérisé**
**en ce qu'**on prévoit le stade de l'introduction de matériau conducteur de charge et de liaison dans l'ouverture de traversée ou dans les ouvertures (5) de traversée.

3. Procédé suivant la revendication 2,
**caractérisé**
**en ce qu'**on introduit de la matière de brasure comme matière conductrice de charge et/ou de liaison dans l'ouverture de traversée ou dans les ouvertures (5) de traversée, et cela notamment par un procédé de dépôt galvanique.

4. Procédé suivant la revendication 3,
**caractérisé**
**en ce qu'**après le stade de
- dépôt de la couche (2) intermédiaire sur la face active de la tranche (7) semi-conductrice
on prévoit le stade d'
- échauffement de la matière de brasure dans l'ouverture de traversée ou dans les ouvertures (5) de traversée, et cela de manière à faire fondre la matière de brasure par l'échauffement et à la faire entrer en liaison conductrice avec des points de contact prévus sur la tranche semi-conductrice.

5. Procédé suivant la revendication 2,
**caractérisé**
**en ce que** l'on introduit de la colle conductrice comme matière conductrice de charge et de liaison dans l'ouverture de passage ou dans les ouvertures de passage, et cela notamment par un procédé à la racle.

6. Procédé suivant la revendication 3,
**caractérisé**
**en ce qu'**après le stade de
- dépôt de la couche intermédiaire sur la face active de la tranche semi-conductrice
on prévoit
- le durcissement de la colle conductrice dans l'ouverture de passage ou dans les ouvertures de passage, et cela de façon à ce que la colle conductrice entre en liaison conductrice avec des points de contact prévus sur la tranche semi-conductrice.

7. Procédé suivant l'une des revendications précédentes, **caractérisé**
**en ce que** l'on effectue le stade du
- dépôt de la couche intermédiaire sur la face active de la tranche semi-conductrice par un procédé de laminage, en utilisant notamment de la pression et de la chaleur.

8. Procédé suivant l'une des revendications précédentes, **caractérisé**
**en ce que** l'on effectue le stade de
- la formation de pistes (9) de conduction dans la feuille (25) de conduction par un procédé en technique d'attaque, par attaque avec enlèvement de parties de la feuille (25) de conduction.

9. Procédé suivant la revendication 8,
**caractérisé en ce qu'**avant le stade d'attaque avec enlèvement de parties de la feuille de conduction, on prévoit le stade d'impression de la feuille de conduction par un vernis d'arrêt d'attaque.
